# EUROPEAN PATENT APPLICATION

(11) **EP 0 731 471 A1**
(43) Date of publication of application: **11.09.1996**
(21) Application number: 95309061.0
(22) Date of filing: 13.12.1995
(51) Int. Cl.: G11C 29/00

(54) **Static random access memories**

(30) Priority: 18.01.1995 GB 9500944
(71) Applicant: PLESSEY SEMICONDUCTORS LIMITED, Swindon, Wiltshire SN2 2QW (GB)
(72) Inventor: Ainsley, Philip I. J., Modbury, Devon PL21 ORG (GB); Phillips, Ian, Woolwell, Plymouth (GB)
(74) Representative: Hoste, Colin Francis

(57) **Abstract**

A method and circuit arrangement for detecting faults in a cell (1) of a static random access memory using a soft write technique is described. The method comprises attempting to change the state of the cell by soft writing to the cell and checking if the cell flips state indicating the presence of a fault in the cell. The method of soft writing to the cell preferably comprises the use of a weak pull-up or pull-down device connected to the input/output of each cell.

## Description

The present invention relates to static random access memories and in particular to a method and arrangement for detecting faults in the cells of such a memory.

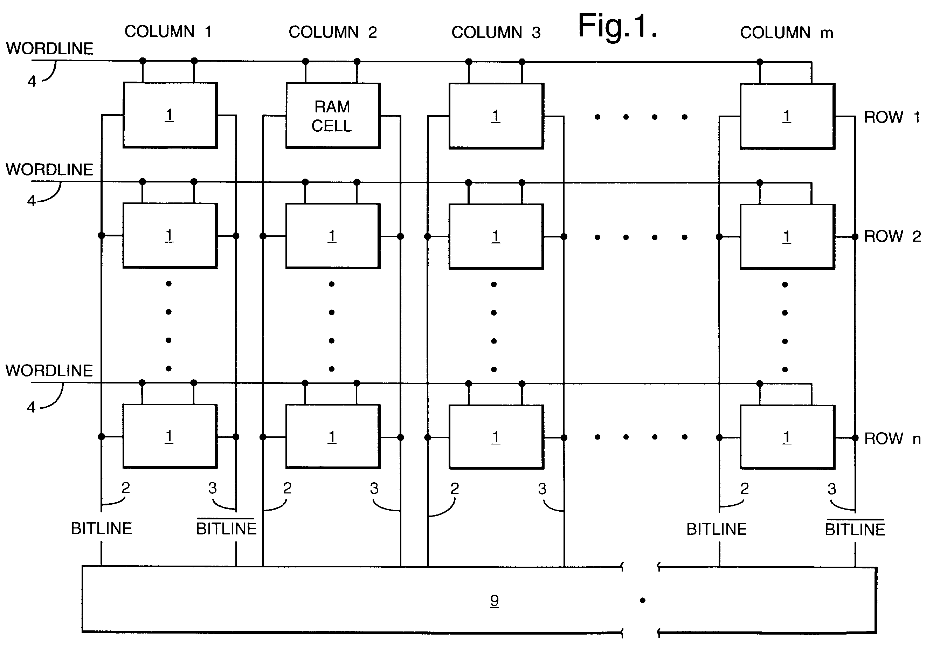

The cost in producing static random access memories (SRAM) is to a large extent associated with quality control checking and testing of the large number of cells that make up the memory. Referring to Figure 1 a schematic of an SRAM is shown and comprises an array of memory cells 1 arranged in 'n' rows and 'm' columns. Each memory cell 1 is capable of storing a single bit of information, that is a '0' or '1', and accordingly is often referred to as a bit cell. Data can be written to, or read from, a memory cell using a pair of bitlines 2, 3 associated with the column in which the cell is located. The required cell within the column is selected by means of a word line 4. The data values applied to the bitlines 2, 3 are the complement of each other and the present state of the cell may be read by measuring the voltage difference appearing across these lines.

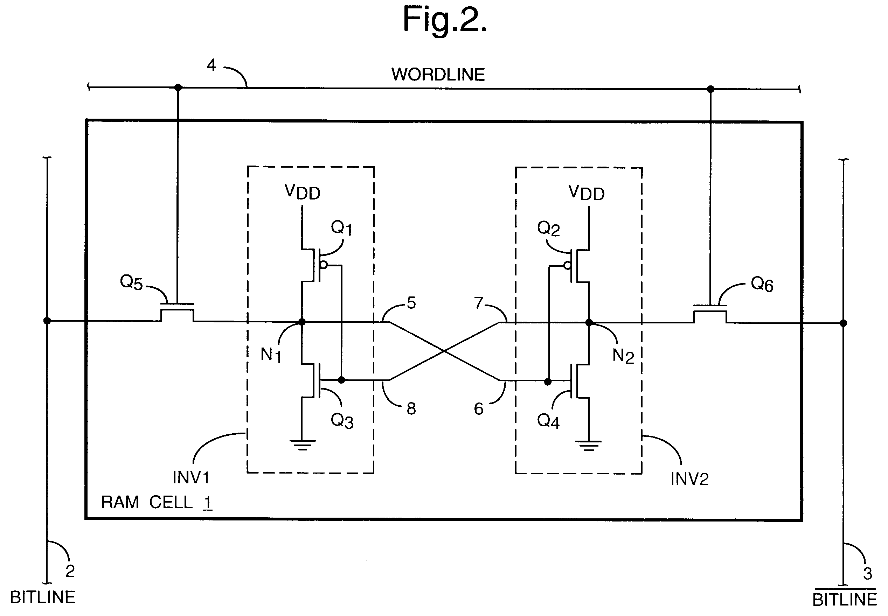

Referring to Figure 2 there is shown a bit cell 1 of the SRAM of Figure 1. The cell 1 comprises a pair of cross-coupled inverters INV1 and INV2. Each inverter INV1, INV2 comprises a pmos field effect transistor (FET), Q₁, Q₂, respectively, and an nmos FET, Q₃, Q₄ respectively, the pmos and nmos FET's in each inverter being connected serially. The inverters INV1, INV2 are cross-coupled to form a latch with output 5 of inverter INV1 connected to input 6 of inverter INV2 and output 7 of inverter INV2 connected to input 8 of inverter INV1. The cell 1 also contains two further nmos FET's Q₅, Q₆, to enable access to the cell's two interior nodes N₁ N₂. The FET's Q₅, Q₆ are controlled by means of a respective word line 4. The present state of the cell 1 is read by activating word line 4, that is, holding it high, to allow the voltages appearing at nodes N₁ and N₂ to affect the voltage on external bitlines 2 and 3 respectively. The voltage difference appearing across bitlines 2, 3 is sensed by read/write circuit means 9. To write the cell to a given state word line 4 is activated and the required logic levels are applied to bitlines 2 and 3 by read/write circuit means 9 to force internal nodes N₁ and N₂ to these levels. The cross-coupled pair of inverters INV1, INV2 which form a latch will sustain a logic level forced on either node N₁ or N₂ indefinitely once the force is removed.

Though only comprising six transistors Q₁-Q₆, each cell is difficult to test thoroughly, primarily due to its internal positive feedback loop and its medium impedance input/output nodes. For example, when the main feedback loop through Q₃, Q₄ and points 5, 6, 7, 8 is not complete because of, say, a break in one of the connections between one of the inverters' outputs and the other inverter's input, then the logic levels forced into the cell by a write operation would still be held and the cell would appear to be functioning correctly. However, the levels would be stored on gate capacitance alone and would therefore only be held for a short period of time.

High performance SRAMs use differential sensing of the voltage or current appearing on lines 2 and 3 to read the present state of the cell. Decisions as to a cell's state are made on the basis of a small, 100 mV or less, voltage difference appearing across lines 2, 3. To decrease access time required to read a cell, bit balancing or pre-charging of the bitlines is used to minimise the disturbance of the cell during a read operation. If, then, one of the cell's interior nodes N₁ or N₂ were floating on a read operation, the state of the cell may still be read correctly. However, with such a finely balanced system, the process of reading the cell's state could cause a significant disturbance within the cell, which in the absence of the positive feedback provided by the main loop would not be pulled back to the correct level. As a result the next time the cell is read its state may have changed.

A number of other fault conditions can occur in which the feedback is single ended, that is, one of the inverters can pull the voltage of the associated node in one direction but not in the other. For example, the node could sustain a low state but not a high state. Such a fault condition is referred to as "weak feedback" and is difficult to identify. The methods proposed for testing for such conditions involve increasing the cell leakage current to accelerate the problems associated with floating nodes. For example, the wafer containing the cells can be irradiated with light during testing, or tests as to the long-term retention of the cells carried out at high temperatures. Other systems have been proposed in which a small group of cells is tested at any given time using what are referred to as "walking patterns" to maximise the difference between the data in a cell and neighbouring cells. Soft defect detects (SDD) have been proposed as described in co-pending application number 9307648.7 in which the cell is written to a given state and the amount of opposition met, if any, is measured when a subsequent attempt is made to change either of the nodes N_{1,} N₂ to the opposite state. In its simplest form this is done by injecting positive and negative current into both cell nodes N₁ and N₂ in turn and detecting any change of voltage more than a few hundred millivolts from either rail. A disadvantage of this system is the speed of operation, since the currents are small and the settling times very long.

A fault condition that is particularly difficult to detect with known methods is the failure of either of the pmos transistors Q₁, Q₂. These transistors pull the nodes N₁ and N₂ up to the rail voltage V_{DD} when activated thereby retaining data in the cell. They are relatively unimportant during any read or write operation and consequently detecting faults in these devices is difficult.

According to a first aspect of the invention there is provided a static random access memory (SRAM) including a circuit arrangement for detecting faults in cells of the SRAM comprising soft write means for attempting to change the state of a cell by soft writing to the cell and checking means arranged to detect if the cell flips states indicating a fault in the cell.

Preferably cells of the memory are arranged in rows and columns with read/write means provided for reading from, or writing to cells by means of a pair of bitlines associated with each column and in which separate soft write means are provided for each bitline.

Advantageously each cell of the memory comprises a pair of cross-coupled inverters each including a pmos pull-up device, and the soft write means comprises an nmos pull-down device connected between the bitline and ground, the nmos pull-down device being weak compared to the pmos pull-up, and the circuit arrangement further including activating means to activate the weak nmos pull-down device.

Conveniently the nmos pull-down device comprises an nmos field effect transistor (FET) activated by means of a test line connected to the gate of the FET and the checking means comprises the read/write means used to read from, and write to, cells of the memory.

According to another aspect of the present invention there is provided a method of detecting faults in cells of a static random access memory (SRAM), the method comprising: attempting to change the state of the cell by soft writing to the cell; and checking if the cell flips state indicating the presence of a fault in the cell.

One embodiment of the invention will now be described by way of example with reference to the accompanying drawings in which:
Figure 1 shows schematically a static random access memory;
Figure 2 shows a cell of the static random access memory of Figure 1; and
Figure 3 shows a test arrangement in accordance with the present invention.

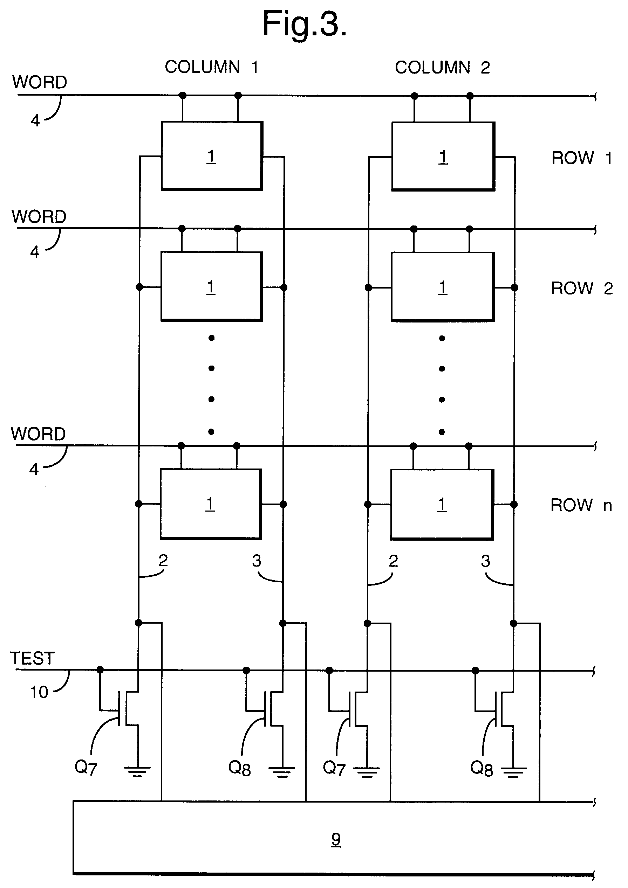

Referring to Figure 3, there is shown part of an SRAM comprising a plurality of cells 1, arranged in two columns, each column containing 'n' rows. Each of the cells 1 comprises cross-coupled inverters as illustrated in Figure 2 and can be written to or read from using respective bitlines 2, 3 and word line 4. Each of the bitlines 2, 3 is switchably connected to ground by means of a respective nmos field effect transistors (FET) Q₇, Q₈. The gate of each FET Q₇ and Q₈ is connected to a test line 10.

To test a cell, the respective word line 4 and test line 10 are set high. Bitlines 2 and 3 are pulled towards ground potential by means of the nmos transistors Q₇, Q₈ thereby pulling nodes N₁ N₂ of the cell under test towards ground. The nmos transistors Q₇, Q₈ are selected such that they are weak in comparison to the pmos devices Q₁, Q₂ which they are pulling against, that is Q₇, Q₈ are less able to draw current than devices Q₁, Q₂. The effect therefore of the weak nmos transistors Q₇, Q₈ when activated is to attempt to "soft write" the nodes of the cell to a ground.

Referring to Figure 1, consider the case when the cell is in a '0' state, that is the cell's nodes N₁ and N₂ are set low and high respectively. In this situation the pmos FET Q₂ will, if functioning correctly, hold node N₂ at the rail voltage V_{DD} despite attempts by the weak nmos device Q₂ to soft write it to ground. Accordingly the cell will remain in a '0' state when the attempt to change its state by soft writing to it has finished. If however Q₂ is not functioning correctly then the weaker nmos FET Q₂ will pull node N ₂ down to ground potential. This causes the cell to regeneratively flip and hold this new '1' state. Consequently when the cell is next read it will contain a different value than expected, indicating the presence of a fault in the pmos pull-up. The pmos pull-up Q₁ associated with the other inverter INV1 can be tested in a similar manner if the cell is first set to the opposite state.

Using this simple arrangement the pair of pmos pull-ups associated with each cell 1 of the SRAM can be tested. An example of a test procedure could be to (a) write all '1's to the SRAM array, (b) activate the weak nmos pull-downs, (c) access all locations, (d) read data from all locations to check for any cells that have flipped state to a '0', (e) write all '0's to the SRAM array, (f) activate the weak nmos pull-downs, (g) access all locations and (h) read data from all locations to check for any cells that flipped to a '1'.

It is envisaged that testing could be applied as a variation on the memory's normal write mode, in which case the strong drivers in read/write circuit 9 used for writing would firstly have to be disabled. Due to the weakness of the pull-down nmos devices Q₇, Q₈, the tests may need to be carried out at reduced speed to allow time for the circuit capacitance to be overcome. For this reason, any self-timing circuits which may be present in read/write circuit 9, such circuits being provided to disable the word line access after a short period, need to be overridden. In addition any bit balancing or pre-charging circuit in read/write circuit 9 which attempts to hold the voltage of the bitlines fixed may also need to be overridden.

Testing could also be carried out as part of the normal read access, for example the cell's state could be read as normal, the weak nmos pull-down activated and cell read once again to check if its state remains unchanged.

An advantage of the present invention is its simplicity with only one extra gate for each bitline being required; this can be integrated as part of the SRAM very cheaply. Secondly, only a single extra test line 10 is necessary. It is envisaged that the present invention would be used in conjunction with normal testing techniques which could detect other faults that may arise in the SRAM. Whilst the present invention can detect failure of one of the pmos devices Q₁, Q₂ in the cell, the method could fail if both pmos FET's within a given cell are faulty, since the cell will not regeneratively latch an error state. In such a situation, both interior nodes N₁ N₂ will be pulled to ground and left in this indeterminate state. It is unlikely, however, that such a condition would not be detected at some point during the test sequence described. To be certain, however, of catching these second order defects, the weak nmos pull-downs Q₇, Q₈ can be controlled independently by separate test lines. During testing only the weak nmos pull-down associated with a node that is expected to be high is activated, thereby only loading the pmos device that is supposed to be activated.

Whilst in the present example the means for soft writing to the cell is provided by weak nmos pull-down FET's, other soft write means are contemplated. For example, weak pmos pull-up devices could be provided to soft write the nodes of the cell to the rail voltages V_{DD} to test the nmos FET's Q₃ and Q₄. Within the present scope of the invention therefore any suitable device could be selected, provided it was weak in comparison to the gate it was testing.

## Claims

1. A static random access memory (SRAM) including a circuit arrangement for detecting faults in cells of the SRAM comprising soft write means for attempting to change the state of a cell by soft writing to the cell and checking means arranged to detect if the cell flips states indicating a fault in the cell.

2. A static random access memory according to claim 1 in which cells of the memory are arranged in rows and columns, further including read/write means for reading from, or writing to cells by means of a pair of bitlines associated with each column and in which separate soft write means are provided for each bitline.

3. A static random access memory according to claim 2 in which each cell of the memory comprises a pair of cross-coupled inverters each including a pmos pull-up device, the soft write means comprises an nmos pull-down device connected between the bitline and ground, the nmos pull-down device being weak compared to the pmos pull-up device, and activating means to activate the nmos pull-down device.

4. A static random access memory according to claim 1 in which the nmos pull-down device comprises an nmos field effect transistor (FET) activated by means of a test line connected to the gate of the FET.

5. A static random access memory according to claim 4 including a separate test line for each bitline.

6. A static random access memory according to claims 2 to 5 in which the checking means comprises the read/write means used to read from, and write to, cells of the SRAM.

7. A static random access memory comprising a plurality of cells arranged in rows and columns, read/write means for reading from or writing to a cell by means of a pair of bitlines associated with each column of the cell and soft write means for attempting to change the state of a cell by soft writing to the cell via the pair of bitlines and checking means arranged to detect if the cell flips states indicating a fault in the cell.

8. A method of detecting faults in cells of a static random access memory (SRAM), the method comprising: attempting to change the state of the cell by soft writing to the cell; and checking if the cell flips state indicating the presence of a fault in the cell.

9. A method according to claim 8 in which the current state of the cell is read before attempting to change the state of the cell by soft writing to it.

10. A method according to claim 8 in which the cell is firstly written to a given state before attempting to change the state of the cell by soft writing to it.
